# EUROPEAN PATENT APPLICATION

(11) **EP 3 621 154 A1**
(43) Date of publication of application: **11.03.2020**
(21) Application number: 18802766.8
(22) Date of filing: 21.03.2018
(51) Int. Cl.: H01Q 1/38

(54) **INTEGRATED ANTENNA PACKAGE STRUCTURE, AND TERMINAL**

(30) Priority: 16.05.2017 CN 201710345411
(71) Applicant: Huawei Technologies Co., Ltd., Longgang District Shenzhen, Guangdong 518129 (CN)
(72) Inventor: LIU, Liangsheng, Shenzhen Guangdong 518129 (CN); LI, Xinhong, Shenzhen Guangdong 518129 (CN); FU, HuiLi, Shenzhen Guangdong 518129 (CN)
(74) Representative: Thun, Clemens
(86) International application number: PCT/CN2018/079855
(87) International publication number: WO 2018/210054

(57) **Abstract**

Embodiments of the present invention disclose an antenna-in-package structure, including a first substrate and a second substrate. A first surface of the first substrate is provided with a first patch antenna, the second substrate is connected to a side of a second surface of the first substrate, and the second substrate is provided with a third surface and a fourth surface that are disposed opposite to each other. The third surface is provided with a second patch antenna, and a projection of the second patch antenna on the first surface at least partially overlaps the first patch antenna. A cavity is disposed between the first substrate and the second substrate, and the second patch antenna is separated from the second surface by the cavity. The fourth surface is provided with a radio frequency element, and the radio frequency element sends and receives a radio frequency signal by using the first patch antenna and the second patch antenna. The antenna-in-package structure provided in the embodiments of the present invention has advantages of low costs and high bandwidth.

## Description

This application claims priority to Chinese Patent Application No. 201710345411.8, filed with the Chinese Patent Office on May 16, 2017 and entitled "ANTENNA-IN-PACKAGE STRUCTURE AND TERMINAL", which is incorporated herein by reference in its entirety.

### TECHNICAL FIELD

The present invention relates to the field of package technologies, and in particular, to an antenna-in-package structure and a terminal having an antenna-in-package structure.

### BACKGROUND

With arrival of an era of high-speed communications such as 5G and VR, a quantity of applications and designs of millimeter-wave antennas is also growing. However, because of a very short wavelength, a millimeter-wave band is highly sensitive to a processing error, and if manufacturing precision is low, no frequency can be matched. Therefore, a conventional PCB machining process can no longer meet a millimeter-wave processing precision requirement. In this case, AIP (Antenna in Package, antenna-in-package technology), a high-precision process required to manufacture and design a millimeter-wave antenna, emerges.

Currently, in the industry, there are researches on AIP antennas made of silicon, ceramic, BT substrates, and other materials. Regardless of which manner is used, to achieve reliable antenna performance, many efforts need to be made at two stages: antenna prototype development, and processing and manufacturing.

It is very necessary to develop a high-bandwidth and high-gain antenna prototype to resist impact of a material error (such as Dk, Df, or CTE) and a processing error on electrical performance, so that reliable antenna performance can be achieved without using an expensive package material and machining process.

### SUMMARY

To resolve the foregoing technical problems, embodiments of the present invention provide an antenna-in-package structure, so that a low-cost, high-bandwidth, and high-gain antenna design is implemented.

According to a first aspect, an embodiment of the present invention provides an antenna-in-package structure, including a first substrate and a second substrate. The first substrate is provided with a first surface and a second surface that are disposed opposite to each other, and the first surface is provided with a first patch antenna. The second substrate is connected to a side of the second surface of the first substrate, the second substrate is provided with a third surface and a fourth surface that are disposed opposite to each other, and the third surface is provided with a second patch antenna. A projection of the second patch antenna on the first surface at least partially overlaps the first patch antenna. A cavity is disposed between the first substrate and the second substrate, and the second patch antenna is separated from the second surface by the cavity. The fourth surface is provided with a radio frequency element, and the radio frequency element sends and receives a radio frequency signal by using the first patch antenna and the second patch antenna.

In this embodiment of the present invention, the cavity is disposed between the first substrate and the second substrate, a gap is formed between the first patch antenna and the second patch antenna by using the cavity, and two substrates including relatively small quantities of layers are lined together. Because a multi-layer dielectric board is replaced with the cavity in this application, the quantities of layers of the substrates can be relatively small. According to the antenna-in-package structure formed in this way, a processing cycle can be shortened, no professional processing capability is required, and manufacturing costs are reduced. In addition, in this embodiment of the present invention, because a medium in the cavity is air, and a dielectric constant is low, high bandwidth and a high gain of a millimeter-wave antenna can be achieved. In comparison with a process of manufacturing a multi-layer board in which a processing error and a link loss occur, this application has an advantage of improving transmit and receive performance of an antenna.

In an implementation, the first surface is further provided with a copper layer, and the copper layer is insulated from the first patch antenna. The copper layer reduces a difference between a copper plating rate of the first surface and copper plating rates of other layers of the first substrate. In a process of manufacturing the first substrate, a reduced difference between the copper plating rates can reduce bubbles and therefore improve a yield rate of manufactured first substrates.

The copper layer may be simply used for balancing the copper plating rate of the first surface, and is not connected to any signal layer or ground plane. In another implementation, the copper layer may be grounded. Specifically, the second substrate is provided with a ground plane, and the copper layer is electrically connected to the ground plane.

In an implementation, the first substrate is provided with a third patch antenna that is disposed on the second surface, and the third patch antenna is located between the first patch antenna and the second patch antenna. The third patch antenna can increase bandwidth of an antenna.

In an implementation, a perpendicular distance between the second patch antenna and the third patch antenna is less than a perpendicular distance between the first patch antenna and the second patch antenna.

In an implementation, a larger distance between the first patch antenna and the second patch antenna leads to higher bandwidth of an antenna.

In an implementation, the first substrate includes at least two layers, and the second substrate includes at least four layers.

In an implementation, the first substrate is connected to the second substrate by using a connector, and the connector, the second surface, and the third surface jointly encircle the cavity.

In an implementation, a groove is disposed on a side that is of the first substrate and that faces the second substrate, the second surface is a bottom wall of the groove, the third surface is connected to an opening position of the groove, and the groove forms the cavity.

In an implementation, a groove is disposed on a side that is of the second substrate and that faces the first substrate, the third surface is a bottom wall of the groove, the second surface is connected to an opening position of the groove, and the groove forms the cavity.

In an implementation, the second patch antenna is provided with a feed point to feed a signal of the radio frequency element into the second patch antenna, to constitute a single-polarized antenna.

In an implementation, the second patch antenna is provided with two feed points to feed signals of the radio frequency element into the second patch antenna, to constitute a dual-polarized antenna.

According to a second aspect, an embodiment of the present invention provides a terminal. The terminal includes a circuit board and the foregoing antenna-in-package structure, and the antenna-in-package structure is disposed on the circuit board.

### BRIEF DESCRIPTION OF DRAWINGS

To describe the technical solutions in the embodiments of the present invention or in the background more clearly, the following briefly describes the accompanying drawings required for describing the embodiments of the present invention or the background.
FIG. 1 is a schematic diagram of a terminal having an antenna-in-package structure according to an embodiment of the present invention;
FIG. 2 is a sectional view of an antenna-in-package structure according to an embodiment of the present invention;
FIG. 3 is a sectional view of an antenna-in-package structure according to another embodiment of the present invention;
FIG. 4 is a sectional view of an antenna-in-package structure according to still another embodiment of the present invention;
FIG. 5 is a sectional view of an antenna-in-package structure according to yet another embodiment of the present invention;
FIG. 6 is a sectional view of an antenna-in-package structure according to still yet another embodiment of the present invention;
FIG. 7 is a schematic diagram of a connector in an antenna-in-package structure according to an embodiment of the present invention;
FIG. 8 is a schematic diagram of a connector in an antenna-in-package structure according to another embodiment of the present invention;
FIG. 9 is a schematic diagram of a cavity architecture formed by a first substrate and a second substrate in an antenna-in-package structure according to an embodiment of the present invention;
FIG. 10 is a schematic diagram of a cavity architecture formed by a first substrate and a second substrate in an antenna-in-package structure according to another embodiment of the present invention;
FIG. 11 is a schematic diagram of a cavity architecture formed by a first substrate and a second substrate in an antenna-in-package structure according to still another embodiment of the present invention;
FIG. 12 is a sectional view of a single-polarized antenna architecture as an antenna-in-package structure according to an embodiment of the present invention;
FIG. 13 is a three-dimensional perspective view of a single-polarized antenna architecture as an antenna-in-package structure according to an embodiment of the present invention;
FIG. 14 is a line graph of a port parameter S of a single-polarized antenna architecture as an antenna-in-package structure according to an embodiment of the present invention;
FIG. 15 is a 3D radiation pattern of a single-polarized antenna architecture as an antenna-in-package structure according to an embodiment of the present invention;
FIG. 16 is a line graph of a radiation field of a single-polarized antenna architecture as an antenna-in-package structure according to an embodiment of the present invention;
FIG. 17 is a three-dimensional perspective view of a dual-polarized antenna architecture as an antenna-in-package structure according to an embodiment of the present invention;
FIG. 18 is a line graph of two port parameters S of a dual-polarized antenna architecture as an antenna-in-package structure according to an embodiment of the present invention;
FIG. 19A and FIG. 19B are a line graph of a radiation field of a dual-polarized antenna architecture as an antenna-in-package structure according to an embodiment of the present invention; and
FIG. 20 is a diagram of circular polarization effects achieved by a dual-polarized antenna architecture as an antenna-in-package structure according to an embodiment of the present invention.

### DESCRIPTION OF EMBODIMENTS

The following describes the embodiments of the present invention with reference to the accompanying drawings in the embodiments of the present invention.

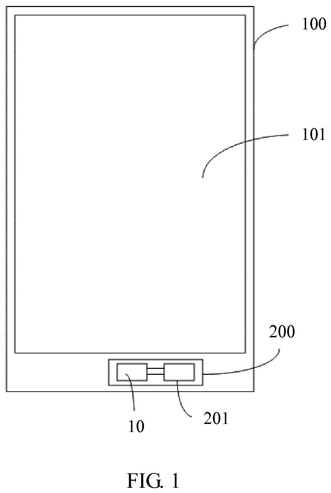

Referring to FIG. 1, a terminal 100 provided in an embodiment of the present invention is equipped with a circuit board 200, an antenna-in-package structure 10 provided in this embodiment of the present invention is disposed on the circuit board 200, and the antenna-in-package structure 10 is electrically connected to a control circuit 201 on the circuit board 200. Specifically, the terminal 100 may be a product such as a mobile phone, a tablet computer, or a router. As shown in FIG. 1, the terminal 100 (for example, a mobile phone) includes a display area 101, the circuit board 200 is disposed on a non-display area, and the circuit board 200 is electrically connected to a mother board in the terminal 100. The antenna-in-package structure 10 is electrically connected to the control circuit 201 on the circuit board 200 through cabling in the circuit board 200.

According to the antenna-in-package structure 10 provided in this embodiment of the present invention, high bandwidth and a high gain of a millimeter-wave antenna can be achieved, and package structure costs are reduced.

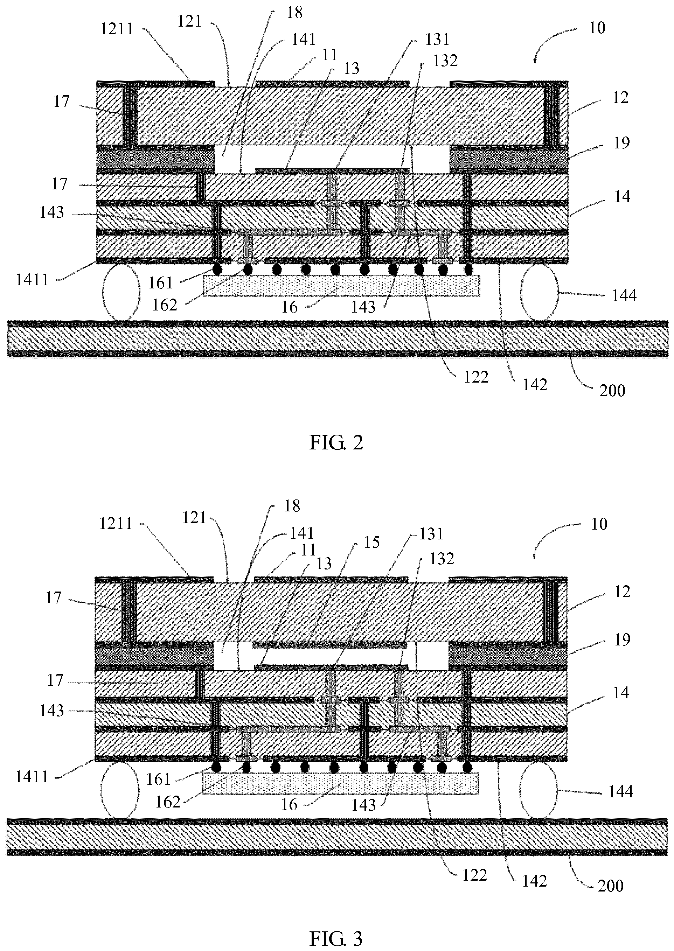

FIG. 2 is a sectional view of an antenna-in-package structure 10 according to an embodiment of the present invention. The antenna-in-package structure 10 includes a first substrate 12 and a second substrate 14. The first substrate 12 is provided with a first surface 121 and a second surface 122 that are disposed opposite to each other. The second substrate 14 is provided with a third surface 141 and a fourth surface 142 that are disposed opposite to each other. The second substrate 14 is connected to a side of the second surface 122 of the first substrate 12, and the first substrate 12 and the second substrate 14 form a laminated structure.

In this implementation, the first substrate 12 is a two-layer substrate architecture. To be specific, there is only a dielectric layer between the first surface 121 and the second surface 122. The second substrate 14 is a four-layer substrate architecture. Two conductor layers are further disposed between the third surface 141 and the fourth surface 142. The conductor layers may be configured to lay a signal cable, a ground cable, a power cable, and the like.

The first surface 121 is provided with a first patch antenna 11. The first patch antenna 11 is a metal layer and serves as an antenna radiator to radiate sent and received signals. In this implementation, the first patch antenna 11 is disposed at an outermost layer of the first substrate 12. In other implementations, the first surface 121 may be alternatively an intermediate layer of the first substrate 12. For example, a protective layer may be further disposed over the first surface 121, and the protective layer is an insulation layer; or a radiation layer may be further disposed over the first surface 121, and the radiation layer is provided with a metal sheet to be coupled to the first patch antenna 11 to enhance signal radiation effects and bandwidth.

The third surface 141 is provided with a second patch antenna 13. The second patch antenna 13 is a metal layer and serves as an antenna radiator to radiate sent and received signals. A projection of the second patch antenna 13 on the first surface 121 at least partially overlaps the first patch antenna 11. Specifically, in an implementation, the first patch antenna 11 and the second patch antenna 13 may be patches in a same shape and fully overlap each other; in another implementation, the first patch antenna 11 and the second patch antenna 13 may be alternatively in different shapes and parallel to each other, and geometric centers of the first patch antenna 11 and the second patch antenna 13 are aligned in a direction perpendicular to the first patch antenna 11; or in other implementations, the first patch antenna 11 and the second patch antenna 13 may be alternatively in a same shape but only partially overlap each other, and form a staggered disposition.

The fourth surface 142 is provided with a radio frequency element 16, and the radio frequency element 16 sends and receives a radio frequency signal by using the first patch antenna 11 and the second patch antenna 13. The radio frequency element 16 is a silicon chip and is provided with an integrated circuit to provide active excitation and provide the first patch antenna 11 and the second patch antenna 13 with feeds. The radio frequency element 16 includes a plurality of pins. A silicon chip may be used as a laminate of the radio frequency element 16. The pin may be a pad disposed on a surface of the silicon chip, and the plurality of pins include a ground pin, a power supply pin, output/output pins, a signal control pin, and the like. The radio frequency element 16 is electrically connected to the second substrate 14 by using the pins. Specifically, in an implementation, the radio frequency element 16 is electrically connected to the second patch antenna 13 by using a combination of a feeder and a through hole. As shown in FIG. 2, the second substrate 14 is a four-layer board. A feeder 143 is disposed at an intermediate layer close to the fourth surface 142. The feeder 143 is electrically connected to a pad 162 on the fourth surface 142 by using a through hole, and the feeder 143 is electrically connected to the second patch antenna 13 on the third surface 141 by using a through hole. In an embodiment shown in FIG. 2, the antenna-in-package structure 10 is a dual-polarized antenna, and two feed points 131 and 132 (in other words, feed ports) are disposed near the second patch antenna 13. The two feed points 131 and 132 are separately electrically connected to the feeder 143 by using through holes, and then the feeder 143 is electrically connected to the pins of the radio frequency element 16 by using through holes.

A cavity 18 is disposed between the first substrate 12 and the second substrate 14, the second patch antenna 13 is separated from the second surface 122 by the cavity 18, and the cavity 18 enables an air layer to be formed between the second surface 122 and the second patch antenna 13. Because an effective dielectric constant of air is 1, compared with another substrate material (whose dielectric constant is usually greater than 3.0), a dielectric constant of the air layer is the lowest. Because operating bandwidth of an antenna is inversely proportional to an effective dielectric constant, a lower dielectric constant leads to higher bandwidth, and a higher dielectric constant leads to lower bandwidth. In other embodiments, the cavity 18 may be alternatively padded with other gas whose dielectric constant is approximately 1.

In this application, when bandwidth of an antenna including the antenna-in-package structure 10 is ensured, a size of the package structure can be reduced. If a substrate material is padded between the first substrate 12 and the second substrate 14 to ensure a distance between the first patch antenna 11 and the second patch antenna 13, because a dielectric constant of the substrate material is greater than the dielectric constant of air, a relatively large gap is required. This needs to be implemented by manufacturing a multi-layer substrate in a manufacturing process, and undoubtedly, manufacturing costs increase. This design of the cavity 18 enables a size of the cavity 18 to be relatively small (smaller than a size of the previously padded substrate material) in a direction perpendicular to the first substrate 12, so that a bandwidth requirement of an antenna is met. In this way, no multi-layer substrate need to be manufactured, and manufacturing costs can be reduced.

In other words, in this embodiment of this application, a gap is formed between the first patch antenna 11 and the second patch antenna 13 by using the cavity 18, and two substrates (namely, the first substrate 12 and the second substrate 14) including relatively small quantities of layers are lined together. Because a multi-layer dielectric board is replaced with the cavity 18, the quantities of layers of the two substrates can be relatively small. According to the antenna-in-package structure 10 formed in this way, a processing cycle can be shortened, no professional processing capability is required, and manufacturing costs are reduced.

In addition, in this embodiment of the present invention, because a medium in the cavity 18 is air, and a dielectric constant is low, high bandwidth and a high gain of a millimeter-wave antenna can be achieved. In comparison with a process of manufacturing a multi-layer board in which a processing error and a link loss occur, this application has an advantage of improving transmit and receive performance of an antenna.

In an implementation, the first surface 121 is further provided with a copper layer 1211, and the copper layer 1211 is insulated from the first patch antenna 11. The copper layer 1211 reduces a difference between a copper plating rate of the first surface 121 and copper plating rates of other layers of the first substrate 12. In a process of manufacturing the first substrate 12, a reduced difference between the copper plating rates can reduce bubbles and therefore improve a yield rate of manufactured first substrates 12. Specifically, the copper layer 1211 is disposed encircling the first patch antenna 11. In other words, the copper layer 1211 is laid around the first patch antenna 11 to improve the copper plating rate of the first surface 121.

Correspondingly, the third surface 141 of the second substrate 14 is also provided with a copper layer, and the copper layer on the third surface 141 is insulated from the second patch antenna 13. A principle of disposing the copper layer on the third surface 141 is the same as a principle of disposing the copper layer on the first surface 121. Bubbles generated in a process of manufacturing the second substrate 14 can be reduced, and therefore a yield rate of manufactured second substrates 14 is improved.

The copper layer 1211 may be simply used for balancing the copper plating rate of the first surface 121, and is not connected to any signal layer or ground plane. In another implementation, the copper layer 1211 may be grounded. Specifically, the second substrate 14 is provided with a ground plane 1411, and the ground plane 1411 is electrically connected to a ground pin 161 of the radio frequency element 16 by using a lead in the second substrate 14. The copper layer 1211 is electrically connected to the ground plane 1411. The copper layer 1211 is electrically connected to the ground plane 1411 by using a ground hole 17, and the ground hole 17 is configured to provide overall signal circulation and heat dissipation for the antenna-in-package structure 10. In an implementation, the ground plane 1411 is disposed on the fourth surface 142 of the second substrate 14, and the ground pin 161 of the radio frequency element 16 is located at an utmost edge location of all the pins of the radio frequency element 16. In other implementations, the ground plane 1411 may be located at another layer of the second substrate 14, including any intermediate layer or the third surface.

The second substrate 14 is connected to the circuit board 200 by using a solder ball 144. The radio frequency element 16 is located between the second substrate 14 and the circuit board 200. The fourth surface 142 of the second substrate 14 may be provided with a plurality of pads that are configured to electrically connect to a circuit on the circuit board 200, and is electrically connected to the circuit board 200 by using the pads, so that a current and a signal can be transmitted between the antenna-in-package structure 10 and the circuit 200.

Referring to FIG. 3, in this implementation, the first substrate 12 is provided with a third patch antenna 15 that is disposed on the second surface 122, and the third patch antenna 15 is located between the first patch antenna 11 and the second patch antenna 13. The third patch antenna 15 can increase bandwidth of an antenna. In this implementation, the first surface 121 and the second surface 122 are two layers of the first substrate 12, no intermediate layer needs to be disposed between the first surface 121 and the second surface 122, and the first patch antenna 11 and the second patch antenna 13 are respectively formed on the first surface 121 and the second surface 122. Because the first surface 121 and the second surface 122 are both surface layers of the first substrate 12, a manufacturing manner is simple.

A perpendicular distance between the second patch antenna 13 and the third patch antenna 15 is less than a perpendicular distance between the first patch antenna 11 and the second patch antenna 13.

In an implementation, the first patch antenna 11 is a square, and a side length of the first patch antenna 11 is a half-wavelength of an operating center frequency of an antenna. A larger distance between the first patch antenna 11 and the second patch antenna 13 leads to higher bandwidth of the antenna.

In an implementation, the first patch antenna 11, the second patch antenna 13, and the third patch antenna 15 are in a same shape, of a same size, and fully overlap each other in a direction perpendicular to the first substrate 12. A design in which three same patch antennas fully overlap each other further helps miniaturize the antenna-in-package structure 10 and can ensure bandwidth and gain performance of an antenna.

In this embodiment of the present invention, the first substrate 12 includes at least two layers, and the second substrate 14 includes at least four layers. According to the antenna-in-package structure provided in this embodiment of the present invention, a four-layer board and a two-layer board may be combined together, and the cavity 18 is disposed at a junction. In this way, the antenna-in-package structure 10 can be formed, and bandwidth and gain requirements can be met. If the cavity 18 is absent, a dielectric layer needs to be padded between the substrates to meet a requirement for isolating the first patch antenna 11 and the second patch antenna 13. In this case, a substrate including more layers (8 layers, 10 layers, or even 12 layers) needs to be manufactured. A procedure of manufacturing the four-layer board and the two-layer board has an advantage of simple manufacturing and low costs in comparison with a procedure of manufacturing an 8-layer board, a 10-layer board, or even a 12-layer board.

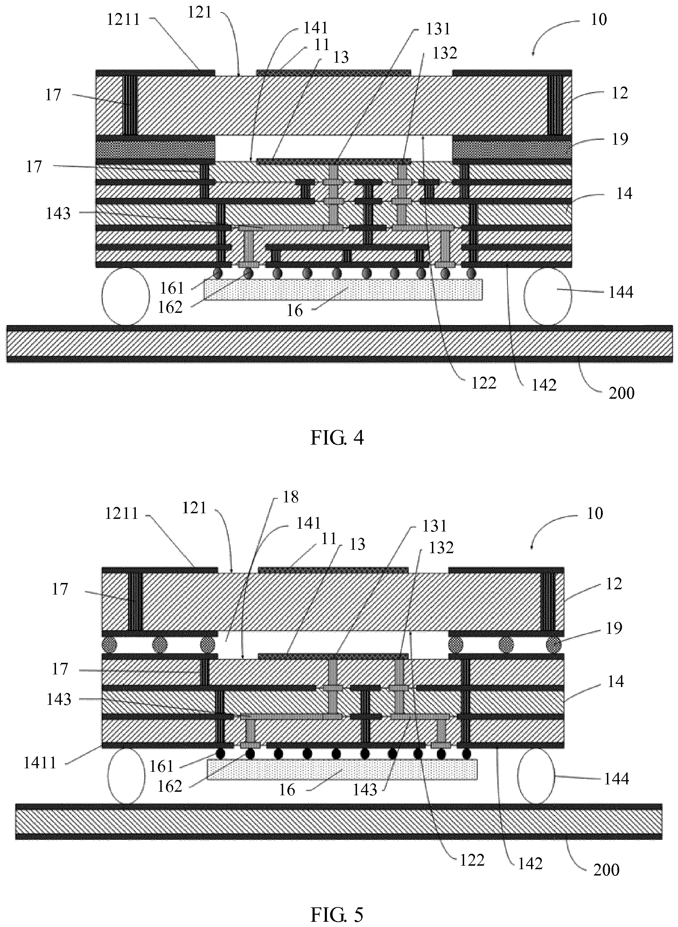

Referring to FIG. 4, in this embodiment, the first substrate 12 is a two-layer substrate, and the second substrate 14 is a six-layer substrate.

As shown in FIG. 2 to FIG. 4, in an implementation, the first substrate 12 is connected to the second substrate 14 by using a connector 19, and the connector 19, the second surface 122, and the third surface 141 jointly encircle the cavity 18. The connector 19 may be a colloid structure, a solder ball, a fixed support, or the like. In this implementation, the second surface 122 of the first substrate 12 and the third surface 141 of the second substrate 14 are both planar, and two ends of the connector 19 are separately connected to the second surface 122 and the third surface 141.

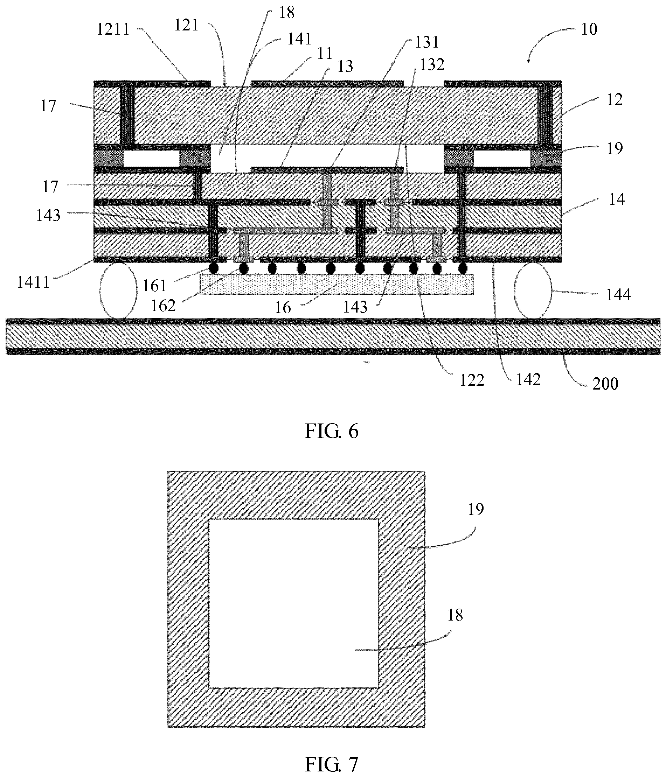

As shown in FIG. 7, the connector 19 may be a continuous frame structure, for example, a plastic frame or an all-in-one bracket. Space encircled by the connector 19 forms the cavity 18. In the embodiment shown in FIG. 7, the connector 19 is a square frame structure. In other embodiments, the connector 19 may be alternatively a rounded or polygonal frame structure.

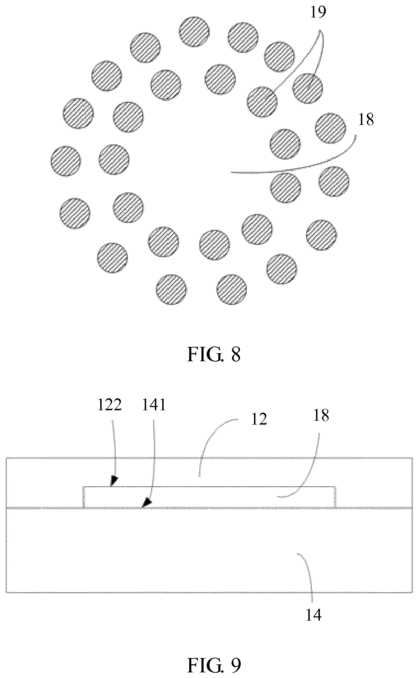

As shown in FIG. 8, the connector 19 may be alternatively a plurality of support structures that are mutually spaced and distributed around the cavity 18, for example, a plurality of solder balls or a plurality of fixing posts. In this implementation, space is propped up between the first substrate 12 and the second substrate 14 by using the connector 19, to form the cavity 18. In the embodiment shown in FIG. 8, a cross section of a single connector 19 is a circle, and the connector 19 may be a cylindrical structure or a ball structure. In other embodiments, a cross section of a single connector 19 may be alternatively a square, a triangle, or a polygon. In the embodiment shown in FIG. 8, connectors 19 are distributed at two layers: an inner circle and an outer circle. Space encircled by the connectors 19 in the inner circle is the cavity 18.

As shown in FIG. 9, FIG. 10, and FIG. 11, the cavity 18 is implemented by digging a groove on the first substrate 12 and/or the second substrate 14, and the first substrate 12 and the second substrate 14 are fixedly connected together, for example, fastened through lining using adhesive or fastened through soldering by using a pad. A fixed connection structure is inadequate to prop up space between the first substrate 12 and the second substrate 14, and therefore cannot form the cavity 18, but is only used to implement a fixed connection. Specific groove digging manners are separately described by using the following three implementations.

In a first implementation, as shown in FIG. 9, a groove is disposed on a side that is of the first substrate 12 and that faces the second substrate 14, the second surface 122 is a bottom wall of the groove, the third surface 141 is connected to an opening position of the groove, and the groove forms the cavity 18.

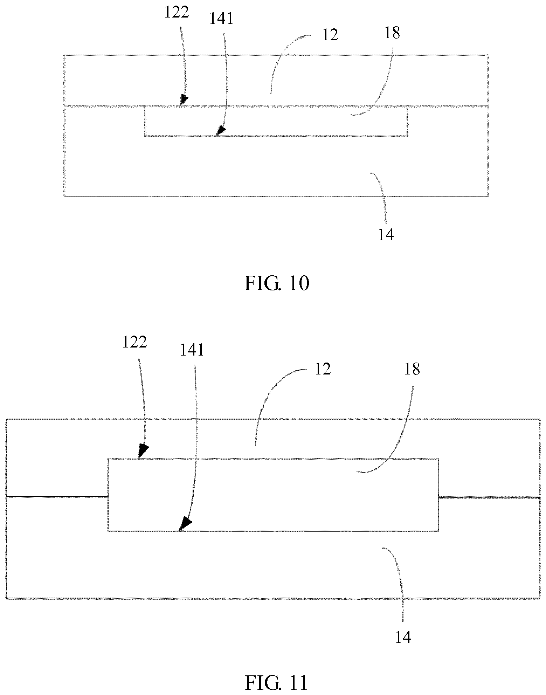

In a second implementation, as shown in FIG. 10, a groove is disposed on a side that is of the second substrate 14 and that faces the first substrate 12, the third surface 141 is a bottom wall of the groove, the second surface 122 is connected to an opening position of the groove, and the groove forms the cavity 18.

In a second implementation, as shown in FIG. 11, grooves are dug in both the first substrate 12 and the second substrate 14. To be specific, a first groove is disposed on a side that is of the first substrate 12 and that faces the second substrate 14, and a second groove is disposed on a side that is of the second substrate 14 and that faces the first substrate 12. The first groove and the second groove are of a same size, so that when the first substrate 12 and the second substrate 14 are lined together, the first groove and the second groove are spliced together to jointly form the cavity 18. In this implementation, the second surface 122 is a bottom wall of the first groove, and the third surface 141 is a bottom wall of the second groove.

In conclusion, a perpendicular distance between the second surface 122 and the third surface 141 is a height of the connector 19 or a thickness of the cavity 18. The height of the connector 19 is a size of the connector 19 in a perpendicular direction between the first substrate 12 and the second substrate 13. In the foregoing implementation in which the cavity 18 is implemented by digging a groove, the thickness of the cavity 18 is a size of the cavity 18 in a perpendicular direction between the first substrate 12 and the second substrate 13. The perpendicular distance between the second surface 122 and the third surface 141 varies depending on different configurations of antenna bands. When an antenna band is 60 GHz, the perpendicular distance between the second surface 122 and the third surface 141 is 30 µm to 100 µm. When an antenna band is 39 GHz, the perpendicular distance between the second surface 122 and the third surface 141 is 65 µm to 150 µm. When an antenna band is 28 GHz, the perpendicular distance between the second surface 122 and the third surface 141 is 100 µm to 400 µm.

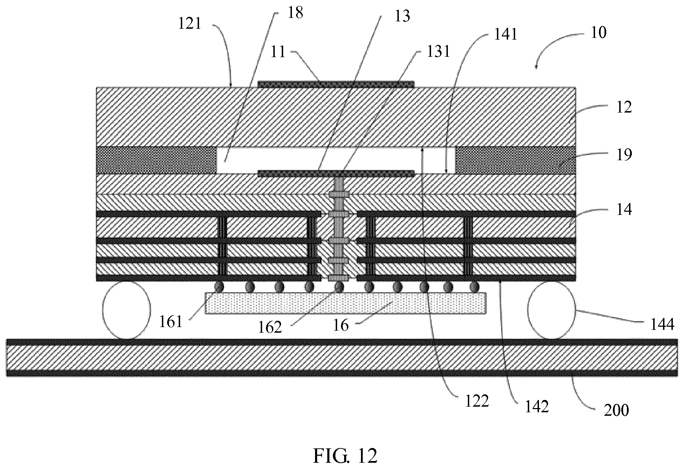

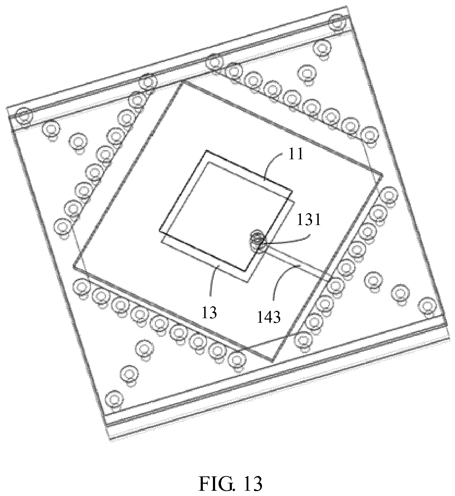

FIG. 12 and FIG. 13 show architectures of single-polarized antennas. The second patch antenna 13 is provided with a feed point 131 to feed a signal of the radio frequency element 16 into the second patch antenna 13, to constitute a single-polarized antenna. In a structural design of the single-polarized antenna, quantities of layers of the first substrate 12 and the second substrate 14 can be relatively small. In an implementation, the first substrate 12 is a two-layer board and is 250 µm in thickness, the second substrate 14 is a six-layer board and is 430 µm in thickness, the height of the connector 19 between the two substrates is 50 µm, and the antenna-in-package structure 10 is 730 µm in total thickness.

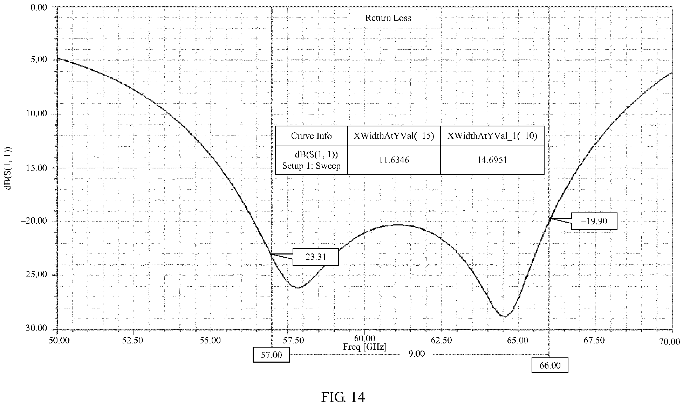

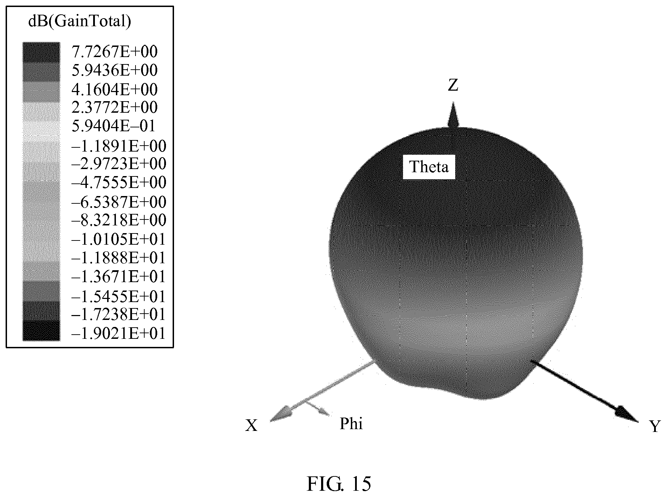

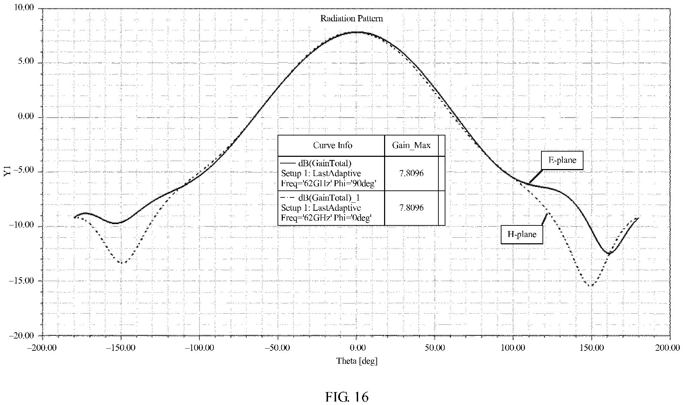

As shown in FIG. 14, FIG. 15, and FIG. 16, antenna-in-package structures 10 of single-polarized antennas provided in the embodiments of this application have high bandwidth and a high gain. In FIG. 14, bandwidth displayed in S11 reaches 14.695 GHz, achieving a high bandwidth percentage of 24.5% (calculated based on a center frequency of 60 GHz). It can be learned from a 3D radiation pattern shown in FIG. 15 that a gain of an antenna reaches 7.726 dB. As shown in FIG. 16, according to radiation field patterns on an E plane and an H plane, field patterns of the two planes are symmetrical, and this greatly helps subsequent array integration. In this embodiment, the bandwidth percentage of 24.5% and the gain of 7.726 dBi indicate that high bandwidth and a high gain are achieved. When an antenna is in a WiGig band and operates at 57 GHz to 66 GHz, a bandwidth percentage is 15%, and a unit gain minus a feeder loss usually needs to be approximately 4 dBi. It can be learned that a great engineering margin is obtained because of performance effects achieved in the present invention. In addition, because two substrates include small quantities of laminated layers, a processing cycle is very short, and a process is mature (a plurality of vendors can provide processing). Because the two substrates are processed at a same time, and then are uniformly packaged, both the processing cycle and processing costs can be greatly reduced.

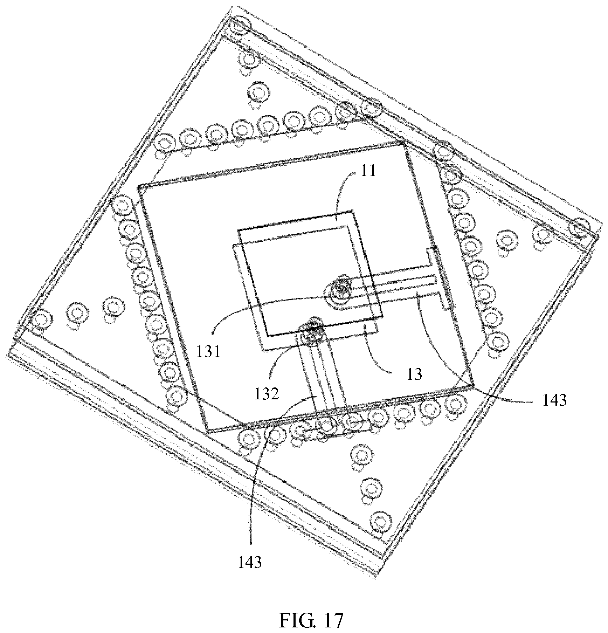

FIG. 4 and FIG. 17 show architectures of dual-polarized antennas. The second patch antenna 13 is provided with two feed points 131 and 132 to feed signals of the radio frequency element 16 into the second patch antenna 13, to constitute a dual-polarized antenna. Specifically, the second patch antenna 13 is square, and two adjacent edges of the second patch antenna 13 each are provided with one feed point to form two excitation ports, in other words, two ports. The two ports operate at a same time and form two polarized surfaces that are perpendicular to each other.

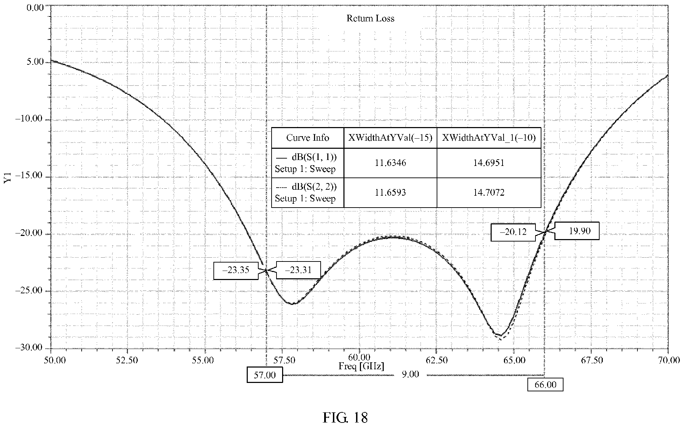

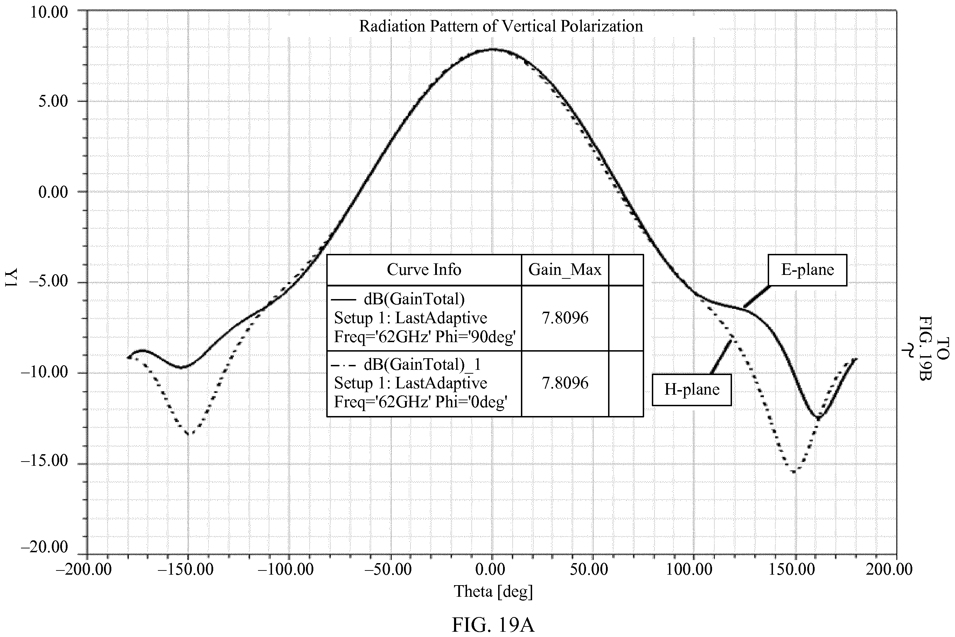

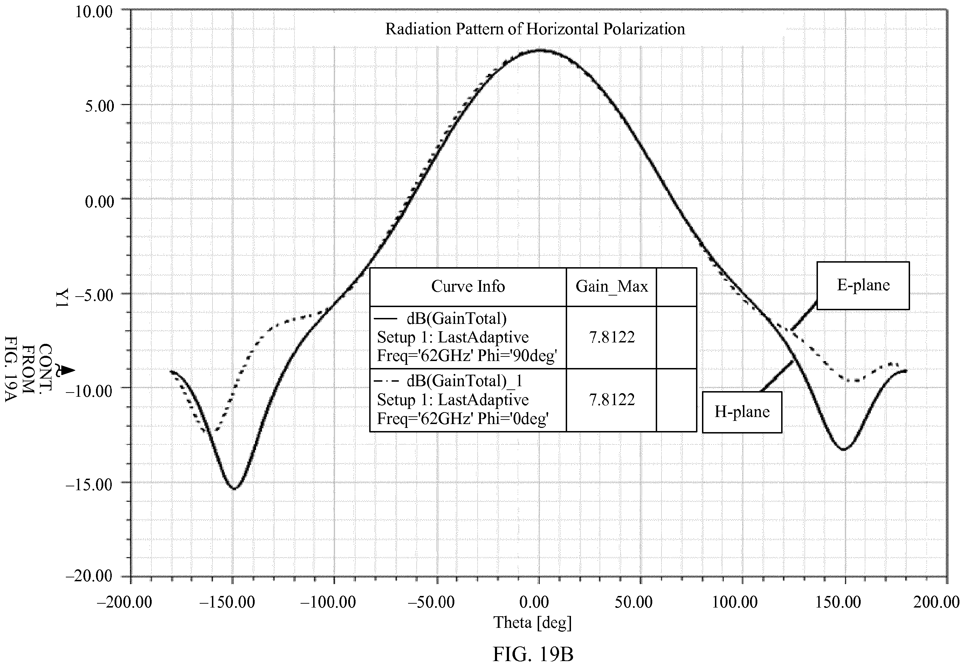

As shown in FIG. 18 and FIG. 19A and FIG. 19B, dual-polarized antennas provided in the embodiments of this application have high bandwidth and a high gain. In FIG. 18, bandwidth displayed in S11 reaches 14.7 GHz, achieving a high bandwidth percentage of 24.5% (calculated based on a center frequency of 60 GHz). It can be learned from FIG. 19A and FIG. 19B that the antenna-in-package structure 10 achieves a high gain of approximately 7.75 dBi in both a horizontal polarization direction and a vertical polarization direction, and according to radiation field patterns on an E plane and an H plane in the polarization directions, field patterns of the two planes are symmetrical, and this also greatly helps a subsequent array integration design.

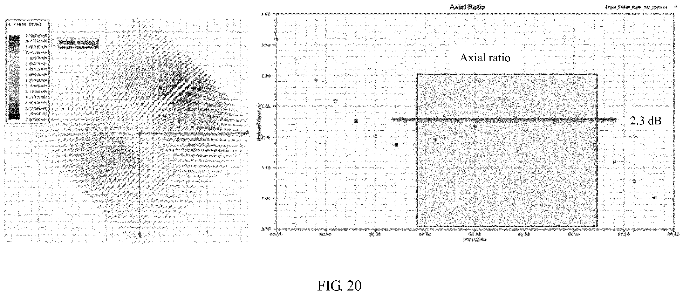

In addition, it can be learned from FIG. 20 that left hand circular polarization, right hand circular polarization, left hand elliptical polarization, and right hand elliptical polarization may be easily applied by controlling amplitudes and phases of the two feed ports.

In conclusion, the bandwidth percentage of 24.5% and the gain of 7.75 dBi indicate that high bandwidth and a high gain are achieved and extensive application forms are brought. In addition, in the WiGig band, a great engineering margin is obtained because of performance effects achieved in the embodiments of the present invention, both a substrate processing cycle and process maturity are excellent, and both the processing cycle and processing costs can be greatly reduced.

## Claims

1. An antenna-in-package structure, comprising:
a first substrate provided with a first surface and a second surface that are disposed opposite to each other, wherein the first surface is provided with a first patch antenna; and
a second substrate connected to a side of the second surface of the first substrate, wherein the second substrate is provided with a third surface and a fourth surface that are disposed opposite to each other, the third surface is provided with a second patch antenna, a projection of the second patch antenna on the first surface at least partially overlaps the first patch antenna, a cavity is disposed between the first substrate and the second substrate, the second patch antenna is separated from the second surface by the cavity, the fourth surface is provided with a radio frequency element, and the radio frequency element sends and receives a radio frequency signal by using the first patch antenna and the second patch antenna.

2. The antenna-in-package structure according to claim 1, wherein the first surface is further provided with a copper layer, and the copper layer is insulated from the first patch antenna.

3. The antenna-in-package structure according to claim 2, wherein the second substrate is provided with a ground plane, and the copper layer is electrically connected to the ground plane.

4. The antenna-in-package structure according to claim 1, wherein the first substrate is provided with a third patch antenna that is disposed on the second surface, and the third patch antenna is located between the first patch antenna and the second patch antenna.

5. The antenna-in-package structure according to claim 4, wherein a perpendicular distance between the second patch antenna and the third patch antenna is less than a perpendicular distance between the first patch antenna and the second patch antenna.

6. The antenna-in-package structure according to claim 1, wherein a larger distance between the first patch antenna and the second patch antenna leads to higher bandwidth of an antenna.

7. The antenna-in-package structure according to claim 1, wherein the first substrate comprises at least two layers, and the second substrate comprises at least four layers.

8. The antenna-in-package structure according to claim 1, wherein the first substrate is connected to the second substrate by using a connector, and the connector, the second surface, and the third surface jointly encircle the cavity.

9. The antenna-in-package structure according to claim 1, wherein a groove is disposed on a side that is of the first substrate and that faces the second substrate, the second surface is a bottom wall of the groove, the third surface is connected to an opening position of the groove, and the groove forms the cavity.

10. The antenna-in-package structure according to claim 1, wherein a groove is disposed on a side that is of the second substrate and that faces the first substrate, the third surface is a bottom wall of the groove, the second surface is connected to an opening position of the groove, and the groove forms the cavity.

11. The antenna-in-package structure according to claim 1, wherein the second patch antenna is provided with a feed point to feed a signal of the radio frequency element into the second patch antenna, to constitute a single-polarized antenna.

12. The antenna-in-package structure according to claim 1, wherein the second patch antenna is provided with two feed points to feed signals of the radio frequency element into the second patch antenna, to constitute a dual-polarized antenna.

13. A terminal, wherein the terminal comprises a circuit board and the antenna-in-package structure according to any one of claims 1 to 12, and the antenna-in-package structure is disposed on the circuit board.
